# DEMANDE DE BREVET EUROPEEN

(11) **EP 0 616 228 A1**
(43) Date de publication de la demande: **21.09.1994**
(21) Numéro de dépôt: 94400547.9
(22) Date de dépôt: 14.03.1994
(51) Int. Cl.: G01R 33/24

(54) **Magnétromètre multiaxial à résonance**

(30) Priorité: 16.03.1993 FR 9303009
(71) Demandeur: COMMISSARIAT A L'ENERGIE ATOMIQUE, F-75015 Paris (FR)
(72) Inventeur: Duret, Denis, F-38100 Grenoble (FR)
(74) Mandataire: Signore, Robert

(57) **Abrégé**

Le magnétomètre de l'invention comprend des moyens (40, 50, 60, Wx, Wy, Wz) d'application séquentielle de champs de polarisation de directions différentes. Il délivre alors (70) les composantes (Hmx, Hmy, Hmz) du champ ambiant selon ces directions.

Application en magnétométrie.

## Description

### Domaine technique

La présente invention a pour objet un magnétomètre multiaxial à résonance. Elle trouve une application dans la mesure des champs magnétiques faibles, par exemple de quelques dizaines de microteslas.

L'invention trouve des applications en géophysique, en prospection minière, en détection spatiale, etc.

### Etat de la technique antérieure

Le magnétomètre de l'invention est du type directionnel à résonnance. Ces appareils sont bien connus et décrits, par exemple, dans la demande de brevet français FR-A-2 663 751 déposée par le présent Demandeur (cette demande contenant elle-même des références bibliographiques sur le sujet), ou dans la demande européenne correspondante EP-A-463 919, ou encore dans l'article de D. DURET, M. MOUSSAVI et M. BERANGER intitulé "Use of High Performance Electron Spin Resonance Materials for the Design of Scalar and vectorial Magnetometers", publié dans la revue IEEE Transactions on Magnetics, vol. 27, n° 6, nov. 1991, pp. 5405-5407.

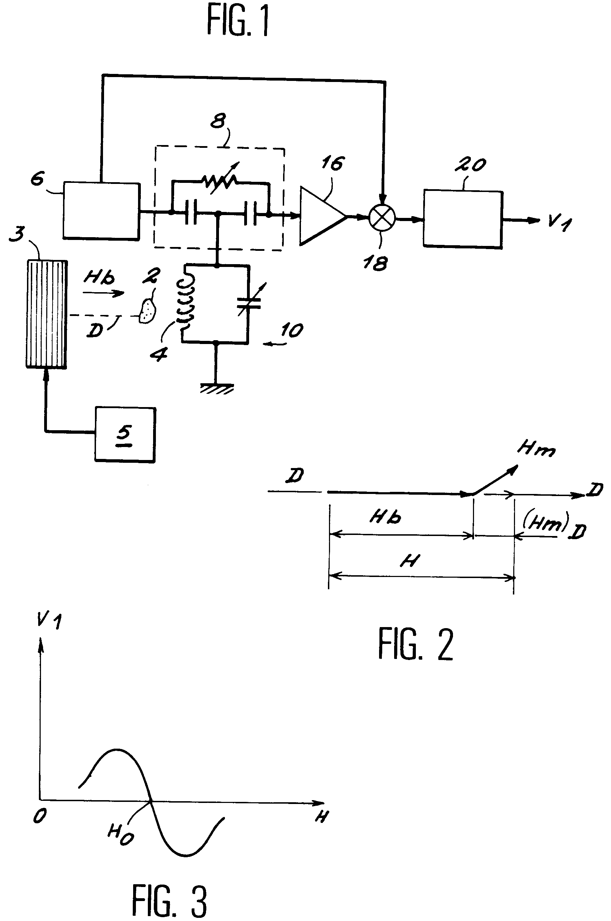

On peut rappeler brièvement la structure et le fonctionnement de ces appareils dans quelques une de leurs variantes et ceci en référence aux figures 1 à 6 annexées.

Sur la figure 1, tout d'abord, on voit un échantillon 2 contenant un matériau possédant des spins électroniques ou nucléaires ; un premier enroulement 3 créant un champ magnétique de polarisation noté Hb et dirigé selon une direction D ; un second enroulement 4 à proximité de l'échantillon 2 ; un générateur de courant 5 d'intensité réglable alimentant le premier enroulement 3 ; un générateur haute-fréquence 6 relié à un pont de mesure 8, lequel est relié à son tour à un circuit résonnant 10 contenant l'enroulement 4 ; un amplificateur à faible bruit 16 relié au pont de mesure 8 ; un mélangeur équilibré 18 recevant, d'une part, la tension délivrée par l'amplificateur 16, et, d'autre part, une tension de référence émanant du générateur haute-fréquence 6 ; et, enfin, un filtre passe-bas 20.

L'échantillon 2 est soumis au champ à mesurer, soit Hm, ainsi qu'au champ de polarisation Hb. Ces deux champs ne sont pas en général colinéaires. Le champ magnétique mesuré par un tel appareil est, en fait, la somme de Hb et de la composante de Hm projetée sur la direction D, composante notée (Hm)_{D}, compte tenu du fait que Hb est beaucoup plus grand que Hm. Ces divers champs ou composantes sont représentés sur la figure 2. Le champ total dans la direction D est noté H.

Le fonctionnement de cet appareil est le suivant.

Le générateur 6, connecté au circuit 10 et à son enroulement 4, est apte à exciter la résonance des spins de l'échantillon 2. Sa fréquence est fixée avec une très grande précision (10⁻⁹ à 10⁻⁶). La résonance des spins se produit lorsque la fréquence fo du signal d'excitation est égale à la fréquence de LARMOR, classiquement déterminée par la relation (1/(2π)) γHo, où γ est le rapport gyromagnétique propre à l'échantillon utilisé (dans le cas de l'électron γ =2π.28 GHz/T) et Ho est la valeur à la résonance du champ magnétique total appliqué.

Le circuit 10 et son enroulement 4 sont, en même temps, aptes à détecter cette résonance, le circuit 8 ayant pour fonction de découpler l'excitation et la détection.

L'appareil représenté sur la figure 1 détecte le passage par la résonance lorsque, la fréquence fo étant fixée, le champ total H passe par la valeur Ho. La figure 3 montre ainsi les variations de la tension V1 délivrée par le filtre passe-bas 20 lorsque le champ H varie et passe par Ho. Cette courbe est du type dispersion, c'est-à-dire antisymétrique, avec une partie positive, une annulation (pour la valeur Ho correspondant à la résonance) et une partie négative. La connaissance de Ho permet de remonter à (Hm)_{D} si l'on connaît Hb.

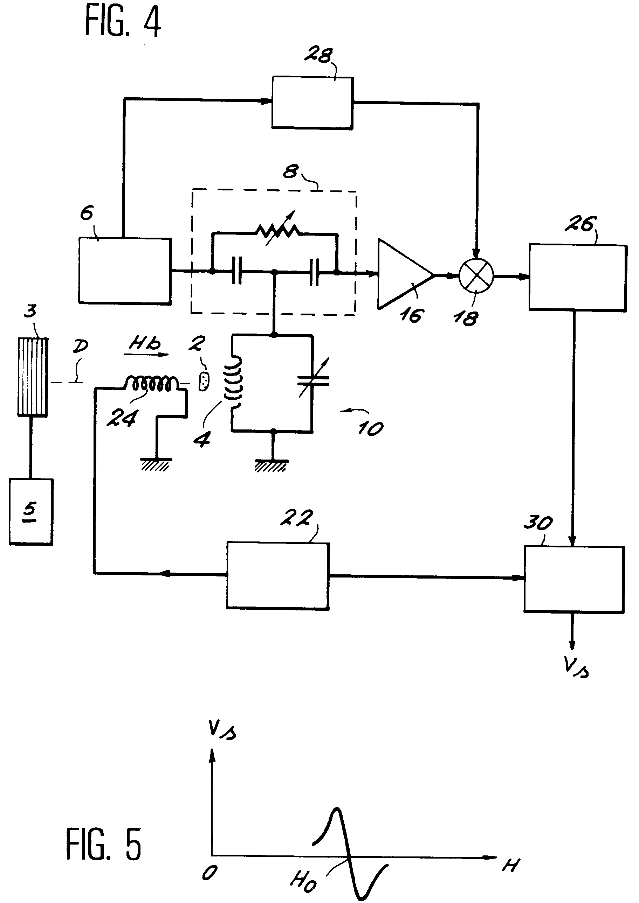

Le dispositif de la figure 4 est une variante dans laquelle on utilise en outre un oscillateur 22 et un enroulement 24 pour engendrer un champ magnétique ayant une fréquence-audio notée fm, ce champ, appelé "champ d'agitation", se superposant au champ de polarisation Hb.

Par ailleurs, dans la variante de la figure 4 et à la sortie du mélangeur équilibré 18, le filtre passe-bas 20 de la figure 1 est remplacé par un filtre passe-bande 26 centré autour de la fréquence fm. Un déphaseur 28 reçoit le signal de haute fréquence issu du générateur 6 et fournit au mélangeur équilibré 18 un signal de phase appropriée.

Un circuit 30 de détection synchrone à la fréquence fm reçoit sur l'une de ses entrées un signal de référence issu du générateur 22. Ce signal de référence possde une fréquence fm mais son amplitude et sa phase peuvent être rendues différentes de celles du signal fourni par l'oscillateur 22 à la bobine 24. Le circuit 30 possède une autre entrée reliée à la sortie du filtre 26 et il délivre finalement une tension Vs.

En montant à la sortie du moyen de détection synchrne 30 un moyen d'observation approprié (non représenté), on peut observer la courbe des variations de Vs en fonction du champ total H. Cette courbe est représentée sur la figure 5. Comme celle de la figure 3, il s'agit d'une courbe antisymétrique avec annulation pour la valeur Ho du champ correspondant à la résonance des spins.

Avec de tels appareils, une variation du champ à mesurer Hm, si elle est très inférieure à la largeur des raies représentées sur les figures 3 et 5, se traduit par un écart par rapport à la valeur de résonance et par l'apparition d'une tension (Vl ou Vs) non nulle en sortie du magnétomètre. Cette tension varie sensiblement linéairement en fonction de l'écart à Ho.

La linéarité peut être améliorée par une contre-réaction de champ, obtenue en se servant de la tension Vl (figure 3) ou de la tension Vs (figure 5) comme signal d'erreur, en intégrant cette tension et en injectant, dans une bobine de contre-réaction, un courant proportionnel à la tension intégrée. L'axe de cette bobine de contre-réaction doit encore être parallèle à la direction D du champ de polarisation.

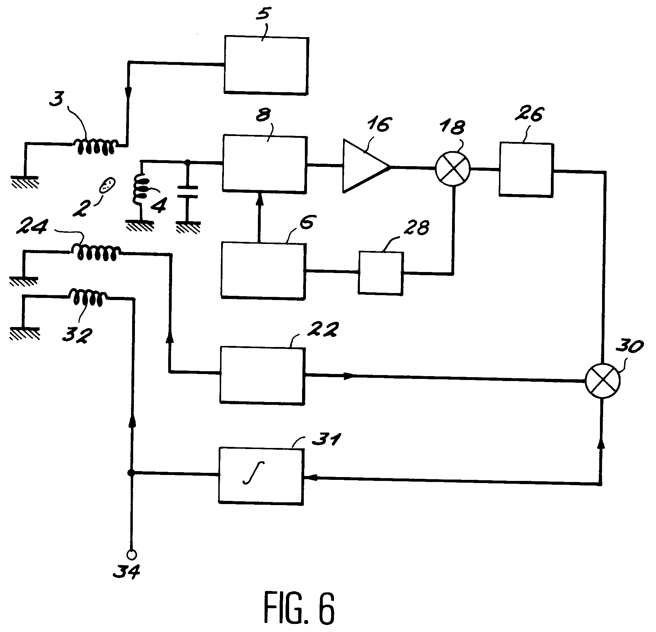

C'est ce qu'on trouve dans le schéma de la figure 6 où apparaissent, en plus des moyens déjà représentés sur la figure 4, un intégrateur 31 et un enroulement 32 de contre-réaction. Dans un tel appareil, le champ total est toujours maintenu à la valeur correspondant à la résonance et le signal d'erreur intégré constitue en fait le signal de mesure. (Ce dernier apparaît sur la sortie 34 de l'appareil).

En d'autres termes, quel que soit le champ appliqué de l'extérieur à l'échantillon, cet échantillon voit, le long de la direction D, le même champ, à savoir celui qui assure la résonance des spins. Comme le champ correspondant à la résonance est beaucoup plus grand (plus de dix fois) que le champ d'origine extérieure à mesurer, le module de la somme vectorielle (cf. fig. 2) est sensiblement égal à la somme du champ crée par le courant de polarisation et dirigé selon la direction D et de la projection sur cette direction du champ extérieur à mesurer.

Autrement dit, les moyens 31 et 32 réalisent un asservissement de l'appareil à la résonance, quel que soit le champ appliqué de l'extérieur.

On peut noter encore que, dans le mode de réalisation illustré sur la figure 6, les trois enroulements, respectivement de polarisation 3, d'agitation 24 et de contre-réaction 32, sont supposés distincts ; mais comme ils ont tous le même axe, ils peuvent très bien être confondus en un seul et même enroulement.

Quant à l'intégrateur 31, il peut soit délivrer directement le courant de contre-réaction, soit délivrer une tension, auquel cas il faut lui associer un convertisseur-courant, sous la forme par exemple d'une résistance.

On retiendra de cet exposé de l'état de la technique, que les magnétomètres directionnels à résonance connus comprennent en général un échantillon à spins soumis au champ à mesurer, des moyens pour appliquer à cet échantillon un champ magnétique de polarisation, des moyens pour appliquer à l'échantillon un champ radiofréquence et exciter la résonance des spins, des moyens pour détecter cette résonance, des moyens pour engendrer un signal électrique antisymétrique qui s'annule lorsque le champ total appliqué à l'échantillon prend la valeur Ho correspondant à la résonance des spins et qui est positif ou négatif selon que le champ total appliqué est plus grand ou plus petit que cette valeur particulière (Ho). En l'absence de champ à mesurer, l'appareil est réglé pour être à la résonance. En présence d'un champ à mesurer, le champ de contre-réaction rétablit la résonance et la valeur du signal d'erreur intégré (ou du courant de contre-réaction) constitue la mesure du champ magnétique.

Les magnétomètres qui viennent d'être décrits sont directionnels, en ce sens qu'ils mesurent la composante du champ selon une direction privilégiée (qui est la direction du champ de polarisation).

Si l'on désire connaître les trois composantes d'un champ selon trois directions rectangulaires, il faut disposer trois magnétomètres avec des champs de polarisation orientés selon ces trois directions et effectuer trois mesures.

L'installation correspondante est donc complexe, coûteuse et encombrante.

### Exposé de l'invention

La présente invention a justement pour but de remédier à ces inconvénients. A cette fin, elle propose un magnétomètre unique, qui est cependant capable de mesurer plusieurs composantes d'un même champ magnétique. En ce sens, le magnétomètre de l'invention peut être qualifié de multiaxial.

En pratique, le magnétomètre de l'invention mesure deux ou trois composantes d'un champ, selon respectivement deux ou trois directions. Dans ce dernier cas, les trois directions sont de préférence orthogonales deux à deux, c'est-à-dire forment un trièdre trirectangle.

Pour obtenir ce résultat, le magnétomètre de l'invention comprend des moyens pour appliquer non plus un mais plusieurs champs de polarisation à l'échantillon, et cela, de manière séquentielle. Pour cela plusieurs enroulements sont prévus autour de l'échantillon avec des moyens appropriés d'alimentation. La sortie du magnétomètre peut délivrer séquentiellement, autant de signaux de mesure qu'il y a de champs de polarisation appliqués séquentiellement à l'échantillon.

De façon précise, la présente invention a pour objet un magnétomètre multiaxial à résonance comprenant :
- un échantillon à spins plongeant dans un champ magnétique à mesurer (Hm) ;
- des premiers moyens pour appliquer à cet échantillon un champ magnétique de polarisation ;
- des deuxièmes moyens d'excitation de la résonance des spins dans l'échantillon ;
- des troisièmes moyens de détection de cette résonance ;
- des quatrièmes moyens pour délivrer un signal qui est nul lorsque le champ appliqué à l'échantillon a une valeur (HO) correspondant à la résonance, et positif ou négatif lorsque le champ appliqué s'écarte de cette valeur (Ho),

ce magnétomètre étant caractérisé par le fait que lesdits premiers moyens pour appliquer à l'échantillon un champ magnétique de polarisation comprennent :
- au moins deux enroulements d'axes non parallèles ;
- des moyens d'alimentation séquentielle de ces enroulements pour appliquer à l'échantillon séquentiellement au moins deux champs de polarisation.

De préférence, les moyens d'alimentation séquentielle des enroulement comprennent :
- un circuit séquenceur apte à délivrer au moins deux signaux de commutation et au moins deux signaux de commande de mesure ;
- un circuit de commutation comprenant au moins deux commutateurs commandés par les signaux de commutation, ces commutateurs étant insérés entre les enroulements et des sources d'alimentation.

Les sources d'alimentation des enroulements peuvent être des sources de courant indépendantes ou être incluses dans d'autres moyens

Tous les moyens connus dans les magnétomètres de l'art antérieur et qui ont été décrits en référence aux figures 1 à 6 peuvent être utilisés dans l'invention, pris seuls ou en combinaison (moyens pour créer un champ d'agitation, moyens de contre-réaction etc.)

### Brève description des dessins

- La figure 1 montre une variante de magnétomètre directionnel à résonance selon l'art antérieur ;
- la figure 2 montre la composition des différents champs en présence ;
- la figure 3 illustre une courbe de dispersion autour de la résonance ;
- la figure 4 montre une autre variante de magnétomètre selon l'art antérieur à champ d'agitation ;
- la figure 5 illustre la courbe de dispersion obtenue avec un magnétomètre de ce dernier type ;
- la figure 6 montre encore une autre variante de magnétomètre selon l'art antérieur à champ d'agitation et à champ de contre-réaction ;
- la figure 7 est un schéma général d'un magnétomètre multiaxial conforme à l'invention ;
- la figure 8 est un chronogramme illustrant les signaux délivrés par le séquenceur ;
- la figure 9 montre un premier mode de réalisation simple d'un magnétomètre selon l'invention ;
- la figure 10 montre un deuxième mode de réalisation plus complexe à champ d'agitation ;
- la figure 11 montre un troisième mode de réalisation encore plus complexe à champ d'agitation et à contre-réaction ;
- la figure 12 montre un quatrième mode de réalisation d'un magnétomètre selon l'invention à plusieurs moyens d'excitation et de détection de la résonance ;
- la figure 13 illustre un triple enroulement réalisé sur un cube ;
- la figure 14 montre un enroulement d'excitation et de détection de la résonance.

### Exposé détaillé d'un mode de réalisation

Dans toute la description qui suit, il sera supposé que l'on applique séquentiellement trois champs de polarisation à l'échantillon. Mais cet exemple n'a rien de limitatif et l'on pourrait très bien n'en appliquer que deux.

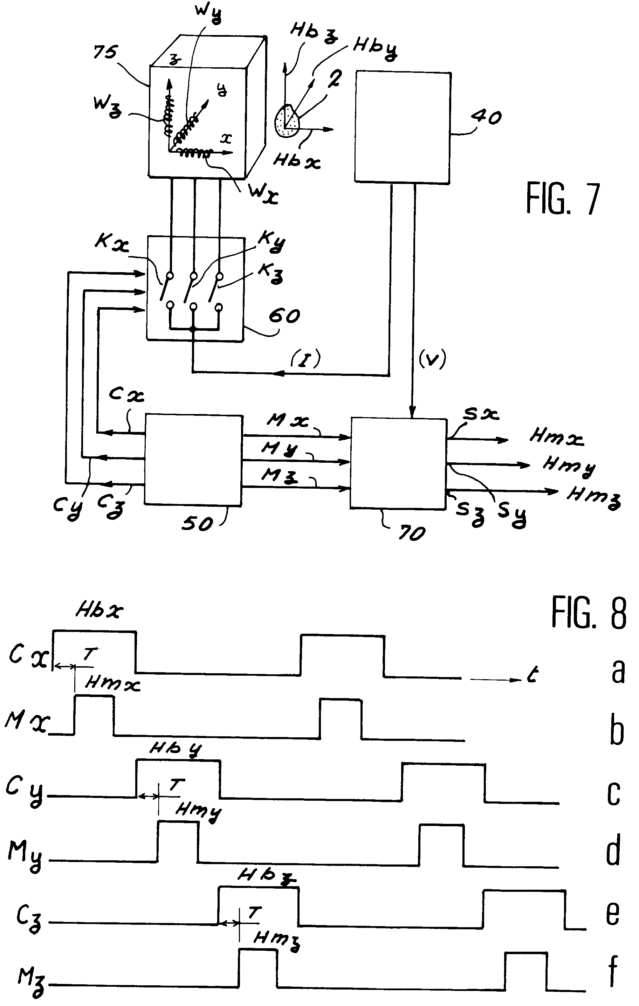

La figure 7 est un schéma général du magnétomètre de l'invention.

Tel que représenté, le magnétomètre comprend un échantillon à spins 2 et des moyens généraux, référencés globalement 40, se rapportant aux divers moyens connus :
- d'excitation et de détection de la résonance ;
- de formation d'un courant I d'alimentation des enroulements de polarisation ;
- le cas échéant, d'agitation et/ou de contre-réaction ;
- de formation d'un signal V qui est le signal de dispersion déjà décrit ou d'un signal de contre-réaction, à partir duquel on peut déduire la valeur du champ magnétique à mesurer.

Le magnétomètre représenté se distingue de l'art connu par la présence d'un circuit séquenceur 50 qui délivre trois signaux de commutation Cx, Cy et Cz et trois signaux de mesure Mx, My et Mz.

Le magnétomètre comprend encore un circuit de commutation 60, relié à 40 comprenant trois interrupteurs Kx, Ky, Kz commandés en ouverture et en fermeture respectivement par les signaux de commutation Cx, Cy et Cz.

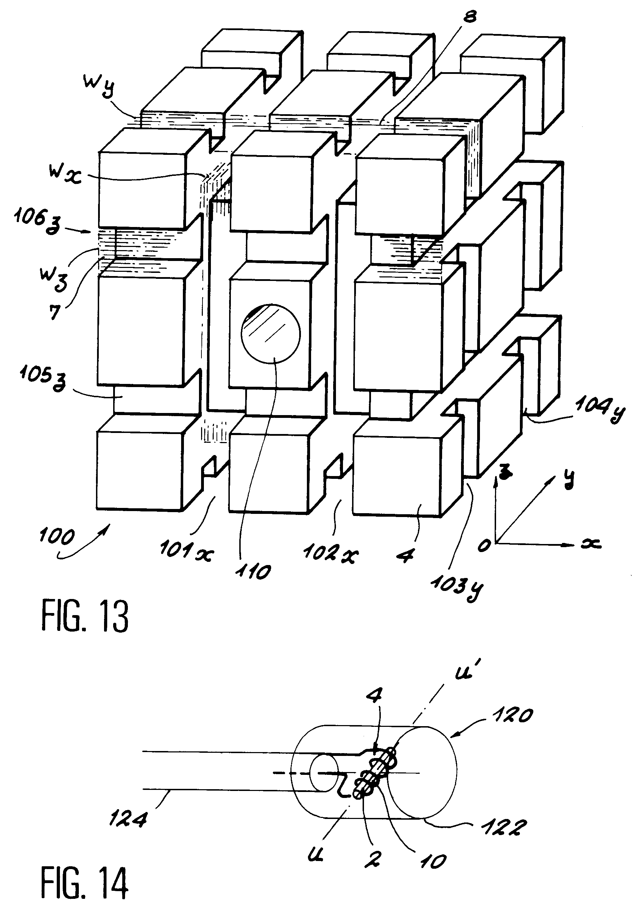

Les moyens de polarisation 75 sont constitués par trois enroulements Wx, Wy et Wz formant un trièdre trirectangle. Les trois champs de polarisation obtenus sont référencés Hbx, Hby et Hbz et sont dirigés selon trois directions qui forment naturellement, elles aussi, un trièdre trirectangle. La figure 7 est schématique. Il faut comprendre que, dans la réalité, les trois enroulements Wx, Wy et Wz entourent l'échantillon 2, comme on le verra mieux à propos de la figure 13.

Le magnétomètre représenté comprend encore un circuit de sortie et de mémorisation 70, qui reçoit le signal V délivré par les moyens 40. Ce circuit de sortie est commandé par les signaux Mx, My et Mz délivrés par le séquenceur 50 et il délivre, sur trois sorties Sx, Sy et Sz, les trois composantes Hmx, Hmy et Hmz du champ Hm à mesurer, dans lequel baigne l'échantillon 2.

Le chronogramme de la figure 8 permet de mieux comprendre le fonctionnement de ce dispositif. Sur les lignes (a), (c) et (e) figurent les signaux de commutation Cx, Cy et Cz. Ils sont présents de manière séquentielle. Lorsqu'ils sont actifs, ils entraînent l'apparition des champs de polarisation Hbx, Hby et Hbz.

Sur les lignes (b), (d) et (f) figurent les signaux de commande de mesure Mx, My, Mz. Ils sont retardés d'une durée T par rapport aux signaux Cx, Cy, Cz. Ils permettent de disposer, sur les sorties appropriées du circuit 70, des composantes du champ, respectivement Hmx, Hmy et Hmz.

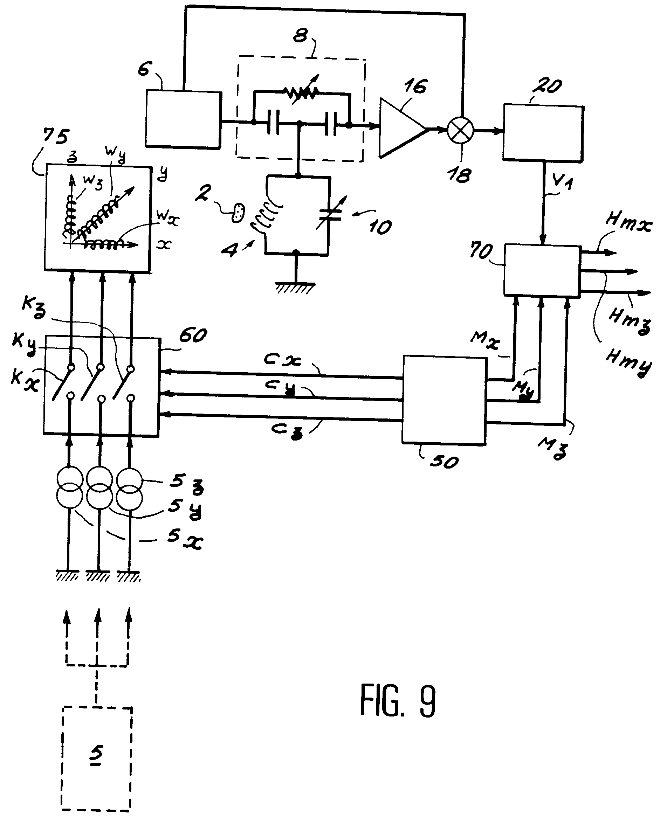

Les figures 9 à 12 illustrent quatre modes de réalisation du magnétomètre de l'invention.

Sur la figure 9, tout d'abord, on voit une variante simple, utilisant des moyens déjà représentés sur la figure 1, à savoir : l'enroulement 4 d'excitation et de détection de la résonance, le générateur haute fréquence 6, le pont de mesure 8, le circuit résonnant 10, l'amplificateur faible bruit 16, le mélangeur équilibré 18 et le filtre passe-bas 20 délivrant un signal Vl.

Par ailleurs, et selon l'invention, le magnétomètre comprend trois sources de courant 5x, 5y et 5z, un circuit de commutation 60, un ensemble 75 à trois enroulements Wx, Wy et Wz, un séquenceur 50 et un circuit de sortie 70 recevant le signal Vl délivré par le filtre passe-bas 20 et délivrant les trois composantes Hmx, Hmy et Hmz du champ à mesurer.

Les moyens 50, 60 et 70 fonctionnent comme déjà décrit à propos des figures 7 et 8.

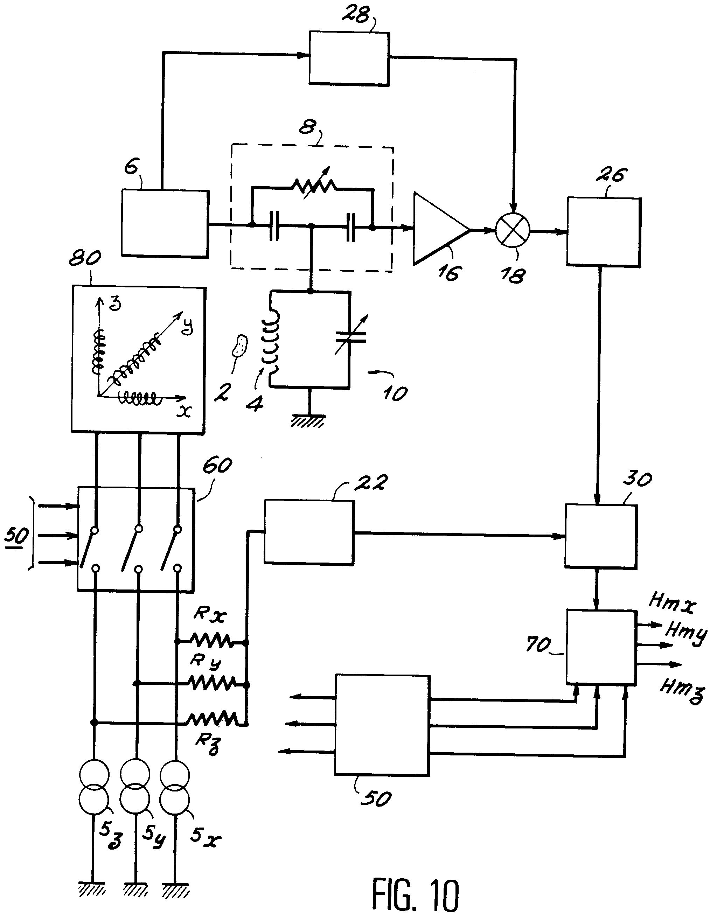

Le mode de réalisation de la figure 10 est un peu plus complexe, en ce qu'il comprend en outre un générateur 22 délivrant une tension à une fréquence audio et trois résistances Rx, Ry et Rz, de connexion de ce générateur aux entrées du circuit de commutation 60. Comme pour la variante de la figure 4, à la sortie du mélangeur équilibré 18, on trouve un filtre passe-bande 26 centré autour de la fréquence audio du générateur 22. Un circuit de détection synchrone 30 reçoit un signal de référence issu du générateur 22 et le signal délivré par le filtre passe-bande 26. Le circuit de sortie 70 délivre encore les trois composantes du champ.

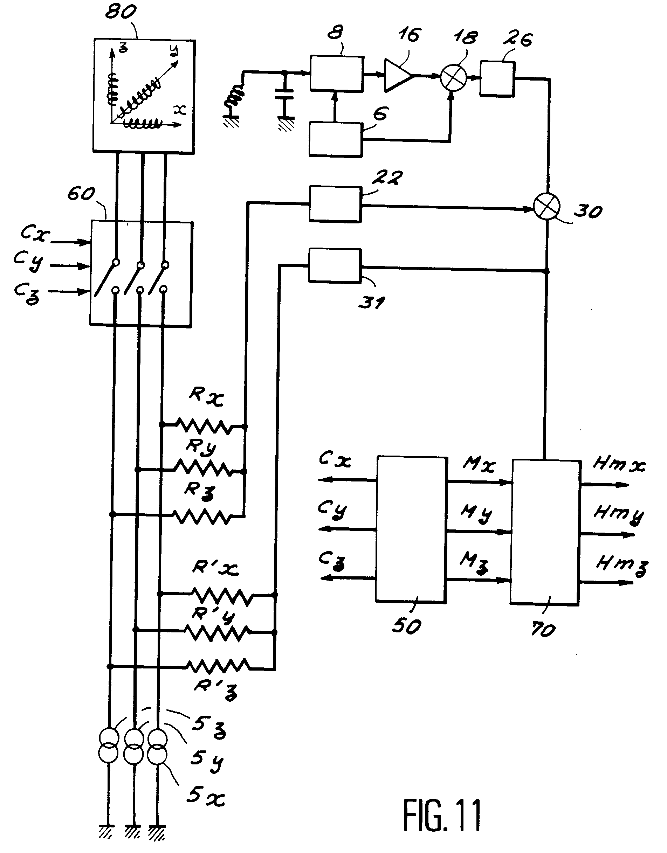

Le mode de réalisation illustré sur la figure 11 est encore un peu plus complexe et correspond à la variante à asservissement par contre-réaction de la figure 6. Il comprend, en plus de l'appareil de la figure 10, un intégrateur 31 et trois résistances R'x, R'y et R'z reliant cet intégrateur au circuit de commutation 60. Le circuit de sortie 70 reçoit la tension de contre-réaction sur une entrée, les trois signaux de commande Mx, My et Mz et délivre les trois composantes Hmx, Hmy et Hmz.

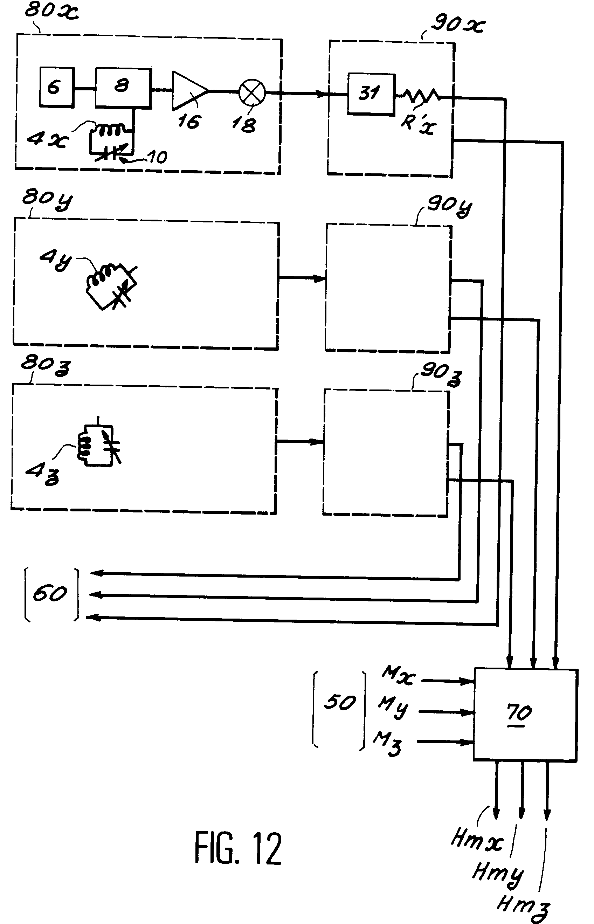

Dans les variantes qui précèdent, le magnétomètre ne comprend qu'un seul enroulement d'excitation et de détection de la résonnce, à savoir l'enroulement référencé 4. Cependant, pour améliorer le rapport signal/bruit, on peut utiliser plusieurs enroulements d'excitation et de détection orientés selon des directions différentes. C'est ce qui est représenté sur la figure 12 où l'on voit trois blocs 80x, 80y et 80z comprenant chacun les mêmes moyens 6, 8, 10, 16, 18 déjà décrits et des enroulements 4x, 4y et4z orientés selon trois axes différents. Le magnétomètre représenté comprend encore trois circuits de contre-réaction 90x, 90y et 90z avec chacun un intégrateur 31 et une résistance R'. Les trois signaux de contre-réaction sont appliqués au circuit de sortie 70 comme dans les autres modes de réalisation.

La figure 13 illustre un bloc 100 permettant de bobiner trois enroulements Wx, Wy, Wz, d'axes orthogonaux x, y, z.

Deux encoches 101x et 102x ont leur axe parallèle à Ox, deux encoches 103y, 104y leur axe parallèle à Oy et deux encoches 105z, 106z leur axe parallèle à Oz. Un fil conducteur isolé est bobiné dans ces encoches et forme des enroulements qui se recouvrent. Les trois champs crées par ces trois doubles enroulements sont homogènes, si avantageusement l'on respecte la condition Z = 0,5545 A, où A désigne le côté moyen d'une gorge et Z la distance entre deux gorges comptée le long d'un axe.

Le trou 110 permet d'introduire l'échantillon et son enroulement d'excitation et de détection.

Le tableau ci-dessous donne quelques caractéristiques possibles pour un cube bobiné avec du fil de 70 µm de diamètre :

| Axe | y | z | x |
|---|---|---|---|
| Demi-côté moyen de la gorge | 7 mm | 6 mm | 5 mm |
| Distance moyenne entre gorges | 3,81 mm | 3,27 mm | 2,72 mm |
| Nombre de spires | 312 | 312 | 312 |
| Résistance | 73Ω | 62Ω | 52Ω |
| Courant | 39 mA | 34 mA | 28 mA |

Le courant indiqué correspond à 1,43mT (ce qui correspond à 40 HMz pour la résonance des spins électroniques).

La figure 14, enfin, montre un moyen d'introduction de l'échantillon à spins à l'intérieur du cube. L'échantillon porte encore la référence 2 et l'enroulement d'excitation et de détection la référence 4. L'ensemble peut être noyé dans une résine ou une colle pour un bon maintien mécanique. Le tout peut être entouré d'un blindage électromagnétique 122. L'ensemble présente un faible volume et une surface extérieure cylindrique dont le diamètre est légèrement inférieur au diamètre du trou 110 percé dans le cube 100 de la figure 13, ce qui permet son introduction. L'enroulement 4 est par ailleurs relié à un câble coaxial de liaison 124 vers le pont 8 (cf. fig. 1).

## Revendications

1. Magnétomètre multiaxial à résonance comprenant :
- un échantillon à spins (2), plongeant dans un champ magnétique à mesurer (Hm)
- des premiers moyens (3, 5) pour appliquer à cet échantillon un champ magnétique (Hb) de polarisation,
- des deuxièmes moyens (6, 8) d'excitation de la résonance des spins dans l'échantillon (2),
- des troisièmes moyens (4, 8) de détection de cette résonance,
- des quatrièmes moyens (16, 18, 20, 26, 28) pour délivrer un signal (Vl, Vs) qui est nul lorsque le champ appliqué à l'échantillon (2) a une valeur (Ho) correspondant à la résonance, et positif ou négatif lorsque le champ appliqué (H) s'écarte de cette valeur (Ho),
ce magnétomètre étant caractérisé par le fait que lesdits premiers moyens pour appliquer à l'échantillon (2) un champ magnétique de polarisation comprennent :
- au moins deux enroulements (Wx, Wy, Wz) d'axes non parallèles,
- des moyens d'alimentation séquentielle de ces enroulements (5x, 5y, 5z) pour appliquer à l'échantillon séquentiellement au moins deux champs de polarisation (Hbx, Hby, Hbz).

2. Magnétomètre selon la revendication 1, caractérisé par le fait que les moyens d'alimentation séquentielle des enroulements (Wx, Wy, Wz) comprennent :
- un circuit séquenceur (50) apte à délivrer au moins deux signaux de commutation (Cx, Cy, Cz) et au moins deux signaux de commande de mesure (Mx, My, Mz),
- un circuit de commutation (60) comprenant au moins deux commutateurs (Kx, Ky, Kz) commandés par les les signaux de commutation (Cx, Cy, Cz), ces commutateurs étant insérés entre les enroulements (Wx, Wy, Wz) et des sources d'alimentation (5x, 5y, 5z).

3. Magnétomètre selon la revendication 2, caractérisé par le fait qu'il comprend un circuit de sortie et de mémorisation (70) commandé par les signaux de commande de mesure (Mx, My, Mz) délivrés par le circuit séquenceur (50), ce circuit de sortie (70) recevant le signal (Vl, Vs) délivré par lesdits quatrièmes moyens (16, 18, 20, 26, 28) et délivrant séquentiellement sur au moins deux sorties (Sx, Sy, Sz) des signaux de mesure (Hmx, Hmy, Hmz) correspondant aux différentes composantes du champ magnétique à mesurer sur les différentes directions des champs de polarisation (Hbx, Hby, Hbz).

4. Magnétomètre selon la revendication 2, caractérisé par le fait qu'il comporte en outre des moyens d'agitation (22, Rx, Ry, Rz) aptes à créer un champ d'agitation, ces moyens comprenant un générateur audio-fréquence (22) relié par au moins deux résistances de connexions au circuit de commutation (60).

5. Magnétomètre selon la revendication 1, caractérisé par le fait qu'il comprend en outre des moyens de contre-réaction (31) reliés au circuit de commutation (60).

6. Magnétomètre selon la revendication 1, caractérisé par le fait qu'il comprend plusieurs deuxièmes et troisièmes moyens d'excitation et de détection de la résonance (80x, 80y, 80z).

7. Magnétomètre selon la revendication 6, caractérisé par le fait qu'il comprend autant de moyens de contre-réaction (90x, 90y, 90z) que de moyens d'excitation et de détection de la résonance (80x, 80y, 80z), ces moyens de contre-réaction étant connectés au circuit de commutation (60).
